# EUROPEAN PATENT APPLICATION

(11) **EP 4 440 255 A1**
(43) Date of publication of application: **02.10.2024**
(21) Application number: 24165784.0
(22) Date of filing: 25.03.2024
(51) Int. Cl.: H05K 5/02, H05K 7/20

(54) **MODULAR FLOOR STAND SYSTEM**

(30) Priority: 29.03.2023 IN 202311023075; 01.03.2024 US 202418593269
(71) Applicant: Vertiv Corporation, Westerville, OH 43082 (US)
(72) Inventor: UMATE, Prashant, Pune (IN); MORDE, Raghavendra, Pune (IN); STIGER, Phil, Marion (US); HOLT, Chad, Cardington (US); DOWELL, DJ, Delaware (US)
(74) Representative: Algemeen Octrooi- en Merkenbureau B.V.

(57) **Abstract**

A modular floor system includes one or more base plates and one or more framing members. The one or more framing members may include one or more vertical framing members and one or more horizontal framing members The system may include one or more sidewall plates configured couple to the one or more framing members to form one or more cavities. The one or more cavities may be configured to support one or more pieces of equipment on the one or more horizontal framing members. The system may include one or more mounting feet configured to mount the one or more modular floor bases to a floor of a data center. A height of the one or more modular floor bases may be configured to be adjusted via the one or more mounting feet.

## Description

### TECHNICAL FIELD

The present invention generally relates to the field of data centers, and more particularly to a modular floor stand system for data centers.

### BACKGROUND

Data centers are frequently designed with raised floors to allow for cabling and cooling air flow to be run under the floor to the equipment located on top of the floor. However, when equipment is installed in raised floor environments, additional equipment in the data center needs to be level with the raised floor equipment. Further, the raised floor may not be suitable to support the additional weight of the additional equipment. As such, it would be advantageous to provide a system or apparatus to remedy the shortcomings of the conventional approaches identified above.

### SUMMARY

According to a first aspect, the present invention provides a modular floor system according to claim 1.is disclosed, The system includes one or more modular floor bases. Each modular floor base includes one or more base plates. Each modular floor base includes one or more framing members, where the one or more framing members include one or more vertical framing members configured to couple to the one or more base plates, where the one or more framing members include one or more horizontal framing members configured to couple to the one or more vertical framing members. Each modular floor base includes one or more sidewall plates, where the one or more sidewall plates are configured to couple to the one or more framing members, where the one or more cavities are configured to support one or more pieces of equipment on the one or more horizontal framing members. Each modular floor base includes one or more mounting feet configured to mount the one or more modular floor bases to a floor of a data center, where a height of the one or more modular floor bases is configured to be adjusted via the one or more mounting feet.

The one or more cavities may be configured to support one or more pieces of equipment on the one or more horizontal framing members to form one or more cavities defined by one or more surfaces of the one or more sidewall plates and the one or more base plates.

According to a second aspect the invention provides a system. The system includes a modular floor stand system according to the first aspect of the invention. the modular floor stand system includes a plurality of modular floor bases, where the plurality of modular floor bases include a first modular floor base arranged adjacent to at least a second modular floor base, where the first modular floor base is configured to support a first piece of equipment of one or more pieces of equipment, where the second modular floor base is configured to support a second piece of equipment of the one or more pieces of equipment. Each modular floor base includes one or more base plates. Each modular floor base includes one or more framing members, where the one or more framing members include one or more vertical framing members configured to couple to the one or more base plates, where the one or more framing members include one or more horizontal framing members configured to couple to the one or more vertical framing members. Each modular floor base includes one or more sidewall plates, where the one or more sidewall plates are configured to couple to the one or more framing members to form one or more cavities defined by one or more surfaces of the one or more sidewall plates and the one or more base plates, where the one or more cavities are configured to support the one or more pieces of equipment on the one or more horizontal framing members. Each modular floor base includes one or more mounting feet configured to mount the one or more modular floor bases to a floor of a data center, where a height of the one or more modular floor bases is configured to be adjusted via the one or more mounting feet. Each modular floor base includes one or more mounting holes configured to receive one or more mounting bolts, where the one or more mounting bolts are configured to couple the first modular floor base of the one or more modular floor bases to the at least the second modular floor base of the one or more modular floor bases arranged adjacent to the first modular floor base.

According to a third aspect, the invention provides a system The system includes one or more pieces of equipment. The system includes a modular floor stand system, where the modular floor stand system is installable on a subfloor of a data center. The modular floor stand system includes one or more modular floor bases. Each modular floor base includes one or more base plates. Each modular floor base includes one or more framing members, where the one or more framing members include one or more vertical framing members configured to couple to the one or more base plates, where the one or more framing members include one or more horizontal framing members configured to couple to the one or more vertical framing members; where the one or more sidewall plates and the one or more base plates define one or more cavities when coupled to the one or more framing members, where the one or more cavities are configured to support one or more pieces of equipment on the one or more horizontal framing members. Each modular floor base includes one or more mounting feet configured to mount the one or more modular floor bases to a floor of a data center, where a height of the one or more modular floor bases is configured to be adjusted via the one or more mounting feet based on a height a raised floor on the subfloor of the data center.

The one or more sidewall plates and the one or more base plates may define one or more cavities when coupled to the one or more framing members

It is to be understood that both the foregoing general description and the following detailed description are exemplary and explanatory only and are not necessarily restrictive of the present invention. The accompanying drawings, which are incorporated in and constitute a part of the specification, illustrate subject matter of the invention. Together, the descriptions and the drawings serve to explain the principles of the invention.

### BRIEF DESCRIPTION OF THE DRAWINGS

The detailed description is described with reference to the accompanying figures. The use of the same reference numbers in different instances in the description and the figures may indicate similar or identical items. Various embodiments or examples ("examples") of the invention are disclosed in the following detailed description and the accompanying drawings. The drawings are not necessarily to scale. In general, operations of disclosed processes may be performed in an arbitrary order, unless otherwise provided in the claims. In the drawings:
FIG. 1A is a simplified block diagram of a modular floor stand system, in accordance with the invention.
FIG. 1B is a schematic view of the modular floor stand system, in accordance with the invention.
FIG. 1C is a schematic view of the modular floor stand system, in accordance with the invention.
FIG. 1D is a schematic view of the modular floor stand system, in accordance with the invention.
FIG. 1E is a schematic view of the modular floor stand system, in accordance with the invention.
FIG. 2A is a simplified block diagram of the modular floor stand system, in accordance with the invention.
FIG. 2B is a schematic view of the modular floor stand system, in accordance with the invention.
FIG. 2C is a schematic view of the modular floor stand system, in accordance with the invention.
FIG. 3A is a schematic view of a mounting foot of the modular floor stand system, in accordance with the invention.
FIG. 3B is a schematic side view of the modular floor stand system, in accordance with the invention.
FIG. 3C is a schematic side view of the modular floor stand system, in accordance with the invention.
FIG. 3D is a schematic side view of the modular floor stand system, in accordance with the invention.

### DETAILED DESCRIPTION

Reference will now be made in detail to the subject matter disclosed, which is illustrated in the accompanying drawings.

Data centers are frequently designed with raised floors to allow for cabling and cooling air flow to be run under the floor to the equipment located on top of the floor. However, when equipment is installed in raised floor environments, additional equipment in the data center needs to be level with the raised floor equipment. Floor stands are often used to allow the equipment to be level with the raised floor and to bear the additional weight of the equipment which the raised floor cannot support.

Accordingly, the present invention is directed to a modular floor stand system. More particularly, the present invention is directed to a modular floor stand system to allow for simplified installation of equipment in raised floor environments. Specifically, the present invention is directed to a modular floor stand system including a single structural assembly that may be used to mount a single piece of equipment and/or multiple pieces of equipment on a single floor stand, rather than several individual floor stands. In this regard, the modular floor stand system reduces part count and design efforts by reducing the need for the factory to stock multiple components/assemblies for multiple individual floor stand designs. Further, the modular floor stand system reduces cost and installation time.

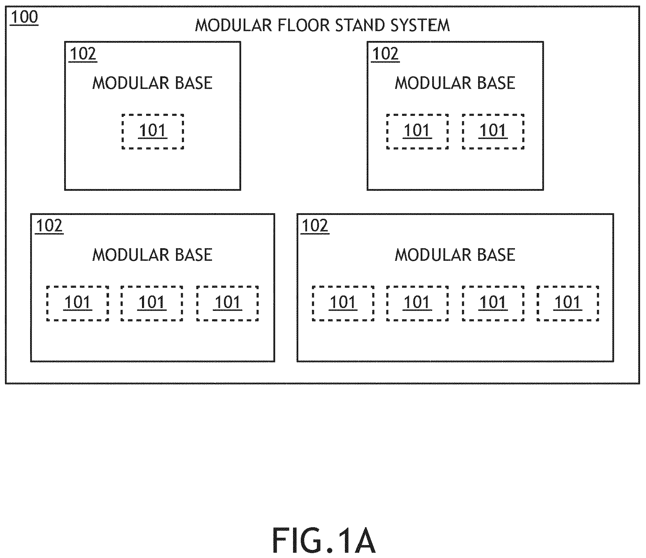

FIGS. 1A-1E illustrate the modular floor system 100, in accordance with the invention. FIGS. 1A-1E are provided merely for illustrative purposes. It is noted that the modular floor system 100 may include any number, shape, size, or configuration of modular floor bases 102 suitable for mounting a variety of equipment configurations. Further, it is noted that the modular floor system 100 and/or one or more components of the modular floor system 100 may be formed of any rigid material suitable for supporting the equipment. For example, the modular floor system 100 and/or one or more components of the modular floor system 100 may be formed of one or more metals.

The modular floor system 100 includes one or more modular bases 102. It is contemplated herein that the modular floor system 100 may include any number of modular bases 102.

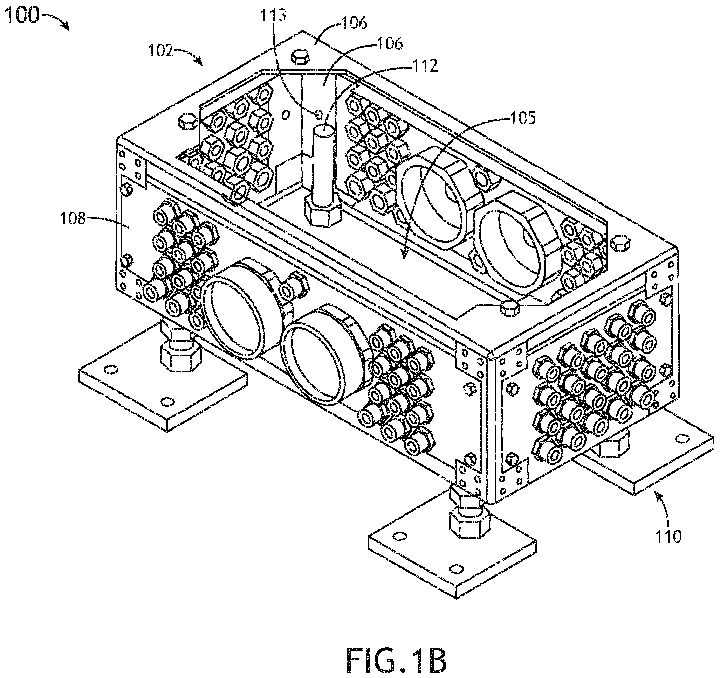

In some embodiments, for example, as shown FIG. 1B, the modular floor system 100 may include a single modular base 102 (i.e., one modular base 102). It is however noted herein that the single modular base 102 may be configured to mount to an additional modular base 102 should additional data center equipment need mounted. For example, the modular base 102 may include one or more mounting holes 113 configured to receive one or more mounting bolts 111, such that the modular base 102 may be mounted to an adjacent modular base 102, as discussed further below.

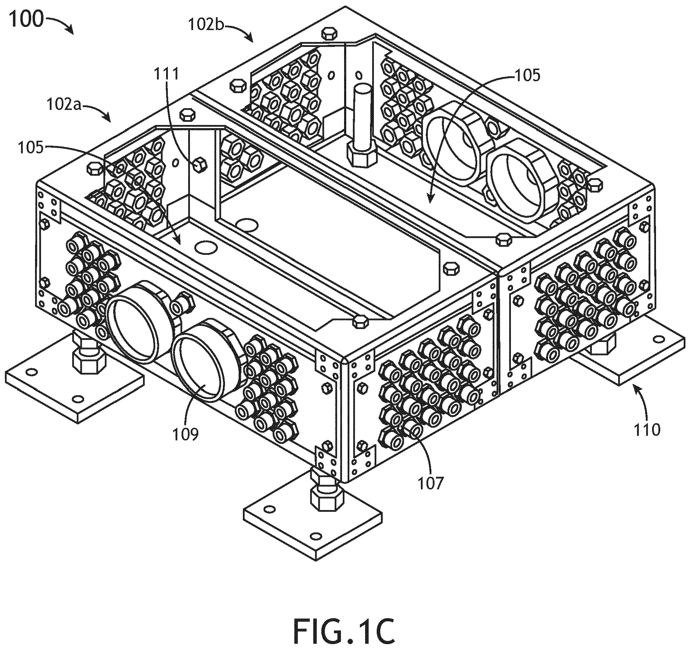

In some embodiments, for example, as shown in FIGS. 1C-1E, the modular floor system 100 includes a plurality of modular bases 102. In this example, each modular base 102 may be coupled to one or more adjacent modular bases 102 to form a single structural assembly configured to mount one or more pieces of equipment. It is noted that a plurality of modular bases may be reversibly coupled to one or more adjacent modular bases via any mounting mechanism. For example, the plurality of modular bases may be coupled to one or more adjacent modular bases via one or more mounting bolts 111.

In a non-limiting example, as shown in FIG. 1C, the modular floor system 100 may include two modular bases 102. For instance, a first modular base 102a may be configured to couple to a second modular base 102b, where the second modular base 102b is positioned adjacent (or next to) the first modular base 102a. In this regard, the first modular base 102a may be mounted to the second modular base 102b via one or more mounting mechanisms (e.g., mounting bolts 111), such that the modular bases 102a, 102b are mounted side-by-side.

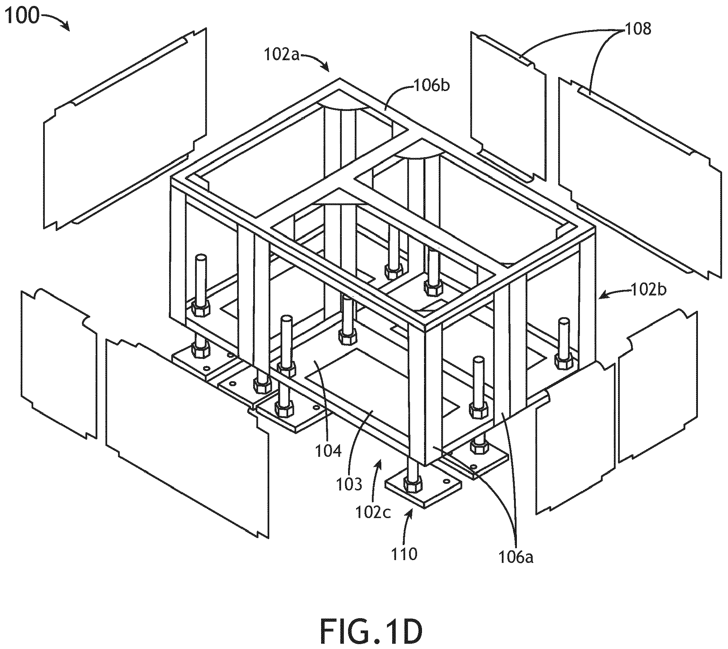

By way of another example, as shown in FIG. 1D, the modular floor system 100 may include three modular bases 102. For instance, a first modular base 102a may be configured to couple to a second modular base 102b positioned in front of the first modular base and a third modular base 102c positioned in front of the first modular base, where the second modular base 102b is positioned adjacent (or next to) the third modular base 102c. In this regard, the first modular base 102a may be mounted to the second modular base 102b and the third modular base 102c via one or more mounting mechanisms (e.g., mounting bolts 111) and the second modular base 102b and the third modular base 102c may be mounted together via one or more additional mounting mechanisms (e.g., additional mounting bolts 111).

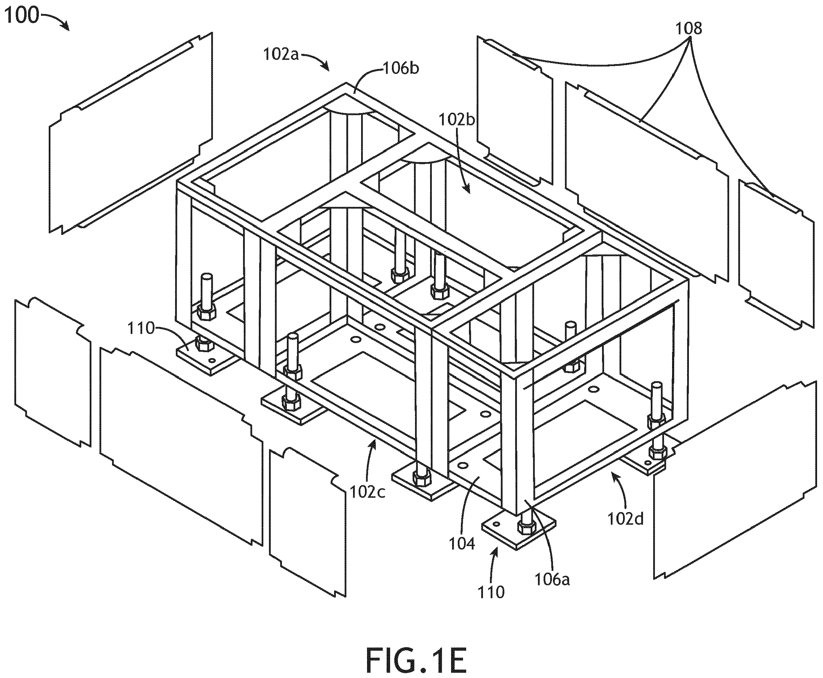

By way of another example, as shown in FIG. 1E, the modular floor system 100 may include four modular bases 102. For instance, a first modular base 102a may be configured to couple to a second modular base 102b positioned in front of the first modular base 102a and a third modular base 102c positioned in front of the first modular base 102a, where the second modular base 102b is positioned adjacent (or next to) the third modular base 102c. Further, a fourth modular base 102d may be configured to couple to the second modular base 102b and the third modular base 102c, where the fourth modular base 102d is positioned in front of the second modular base 102b and the third modular base 102c. In this regard, the first modular base 102 may be mounted to the second modular base 102b and the third modular base 102c via one or more mounting mechanisms and the second modular base 102b and the third modular base 102c may be mounted together via one or more additional mounting mechanisms. Further, the fourth modular base 102d may be mounted to the second modular base 102b and the third modular base 102c via one or more additional mounting mechanisms.

Each modular base 102 includes one or more base plates 104 for supporting data center equipment. For example, as shown in FIGS. 1D-1E, each modular base 102 may include a rectangular base plate 104. It is noted that the one or more base plates 104 may be any shape/size suitable for supporting data center equipment in a raised floor environment.

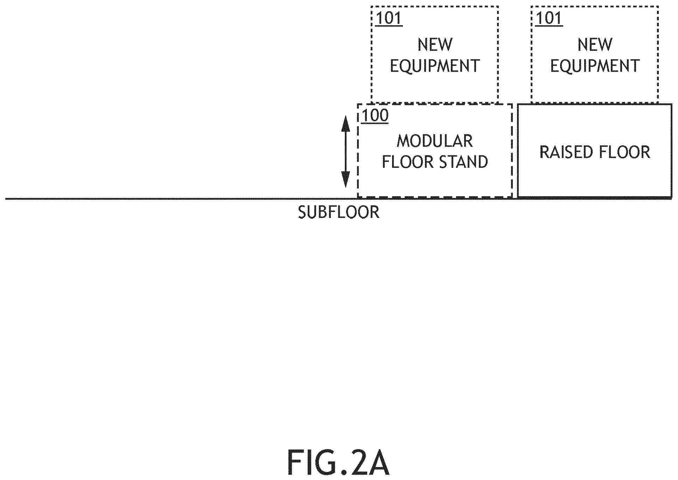

FIGS. 2A-2C illustrate the modular floor stand system 100 including one or more pieces of equipment 101, in accordance with the invention. It is contemplated herein that the modular floor system 100 may allow one or more pieces of equipment 101 to be mounted on the one or more modular bases 102 via any number of configurations, such that the one or more pieces of equipment may be level with the raised floor, as shown in an exemplary manner in FIGS. 2A-2C.

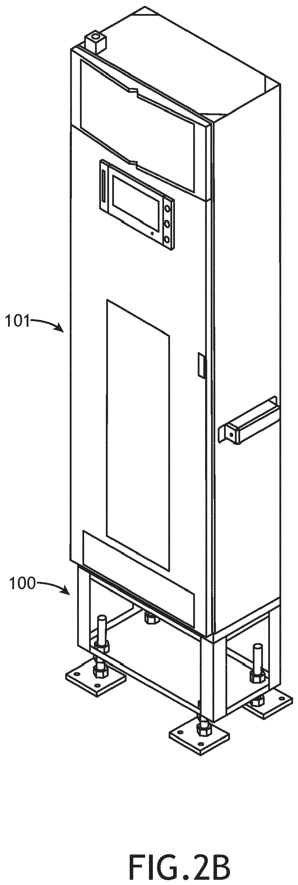

In a non-limiting example, as shown in FIG. 2B, the modular floor system 100 may include a single modular base 102 configured to store a single piece of equipment 101.

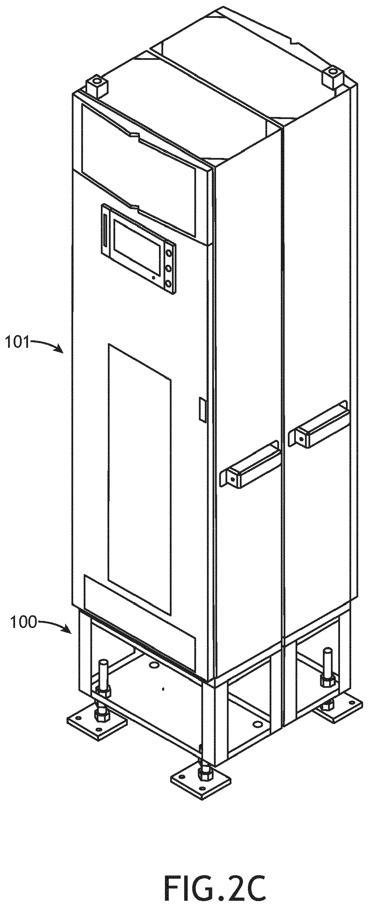

By way of another non-limiting example, as shown in FIG. 2C, the modular floor system 100 may include two adjacent modular bases 102 configured to mount two pieces of equipment 101.

As previously discussed herein, it is contemplated herein the modular floor stand system 100 may allow for simplified installation of equipment in raised floor environments by providing a modular system able to dynamically adapt to the data center equipment configuration (e.g., number, arrangement, or the like of equipment).

Referring back to FIGS. 1A-1E, in some embodiments, the one or more base plates 104 may include one or more perforations 103. For example, as shown in FIGS. 1B-1C, the one or more base plates 104 may include a section with one or more perforations 103. For instance, the one or more base plates 104 may include a middle section with one or more perforations 103. In this regard, the one or more perforations 103 in the one or more base plates 104 may allow cool air to flow from the floor to the equipment above. Further, the one or more perforations 103 in the one or more base plates 104 may prevent rodents, debris, or the like from entering the cavity.

Each modular base 102 further includes one or more framing members 106. For example, as shown in FIGS. 1D-1E, the modular base 102 includes one or more vertical framing members 106a coupled to one or more portions of the base plate 104. For instance, as shown in FIGS. 1D-1E, each modular base 102 may include one or more vertical framing members 106a positioned at one or more corners of the rectangular base plate 104. In this regard, the rectangular base plate 104 may include eight vertical framing members 106a, where a first set of two vertical framing members 106a is coupled to a first corner, a second set of two vertical framing members 106a is coupled to a second corner, a third set of two vertical framing members 106a is coupled to a third corner, and a fourth set of two vertical framing members 106a is coupled to a fourth corner.

Although FIGS. 1D-1E depict the one or more corners of the base plate 104 including two vertical framing members 106a, it is noted that the base plate 104 may include any number and configuration of vertical framing members 106a. For example, the modular base 102 may include a single vertical framing member 106a positioned at the one or more corners of the base plate 104, such that the base plate 104 includes four vertical framing members 106a. By way of another example, the base plate 104 may include one or more vertical framing members 106a positioned at one or more edges of the base plate 104.

By way of another example, as shown in FIGS. 1B-1E, the modular base 102 may include one or more horizontal framing members 106b. For example, the modular base 102 may include a horizontal framing member 106b coupled to one or more of the one or more vertical framing members 106a. For instance, as shown in FIGS. 1B-1E, the one or more vertical framing members 106a may be coupled to the horizontal framing member 106b at one or more corners of the horizontal framing member 106b. In this regard, the horizontal framing member 106b may coupled to the first set of vertical framing members 106a at the first corner, the second set of vertical framing members 106a at the second corner, the third set of vertical framing members 106a at the third corner, and the fourth set of vertical framing members 106a at the fourth corner. Further, as shown in FIGS. 1B-1E, the horizontal framing members 106b when coupled to the set of vertical framing members 106a may define a opening (or cut out) on a top side of the modular base 102, such that wires from the equipment (as shown in FIGS. 2A-2C) may enter the bottom of the attaching unit.

Although FIGS. 1B-1E depict the modular base 102 including a single horizontal framing member 106b, it is noted that the modular base 102 may include a plurality of horizontal framing members.

Each modular base 102 further includes one or more sidewall plates 108 configured to couple to at least one of the plurality of vertical framing members 106a. For example, as shown in FIGS. 1B-1C, each sidewall plate 108 may be configured to coupled to one or more portions of the one or more vertical framing members 106a and the one or more horizontal framing members 106b. In one instance, as shown in FIG. 1B, a first sidewall plate may be coupled to a first side of the modular base 102 (e.g., front side), a second sidewall plate may be coupled to a second side of the modular base (e.g., left side), a third sidewall plate may be coupled to a third side of the modular base (e.g., rear side, and a fourth sidewall plate may be coupled to a fourth side of the modular base (e.g., right side). In this regard, one or more surfaces of the one or more base plates 104 and the one or more sidewall plates, when coupled to the respective framing members 106, may define a cavity 105 configured to support one or more pieces of equipment 101 (e.g., server racks, HVAC equipment systems, and the like) on the one or more horizontal framing members 106b.

In another instance, as shown in FIG. 1C, a first sidewall plate may be coupled to a first side of the first modular base 102 (e.g., front side), a second sidewall plate may be coupled to a first side of the second modular base (e.g., front side), a third sidewall plate may be coupled to a second side of the second modular base (e.g., right side), a fourth sidewall plate may be coupled to a third side of the second modular base (e.g., rear side), a fifth sidewall plate may be coupled to a second side of the first modular base (e.g., rear side), and a sixth sidewall plate may be coupled to a third side of the first modular base (e.g., right side). In this regard, the one or more base plates 104 and the one or more sidewall plates 108, when coupled to the respective framing members 106 of the first modular base and second modular base, may define one or more cavities 105 configured to support one or more pieces of equipment 101 (e.g., server racks, HVAC equipment system, and the like) on the one or more horizontal framing members.

In some embodiments, the one or more sidewall plates 108 may include one or more perforations 107. For example, the one or more sidewall plates 108 may include one or more sections with one or more perforations 107. In this regard, the one or more perforations in the one or more sidewall plates 108 may allow cool air to flow into the one or more cavities 105.

In some embodiments, the one or more sidewall plates 108 may include one or more openings 109. For example, the one or more sidewall plates 108 may include one or more cable openings 109 configured to receive one or more cables from the equipment mounted within the one or more cavities 105 of the modular bases 102.

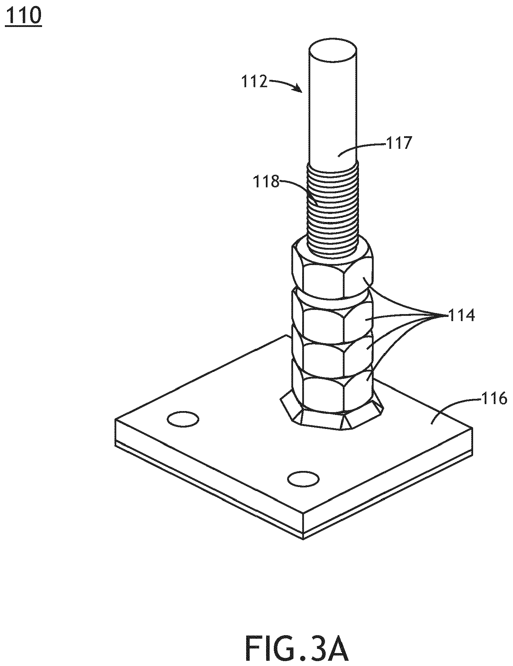

FIGS. 3A-3D illustrate the one or more mounting feet 110 of the modular floor system 100, in accordance with the invention.

Each modular base 102 may be coupled to one or more mounting feet 110 configured to mount the modular base 102 to the subfloor, as shown in FIG. 3A. The one or more mounting feet 110 may be coupled to each modular base 102 via any coupling/fastening method. For example, the one or more mounting feet 110 may include, but are not limited to, a threaded fastener 112, one or more nuts 114, and a base 116. For instance, the base 116 may couple to (or be integrated with) the threaded fastener 112, where a vertical shaft 117 of the threaded fastener 112 includes a threaded portion 118 configured to couple to a complementary threaded portion on the one or more nuts 114.

The height of each modular base 102 may be adjusted via the one or more mounting feet 110, such that the equipment supported by the modular floor system 100 may be level with the raised floor. For example, a vertical position along the shaft 117 of the threaded fastener 112 may be selected based on a height of the raised floor, such that a height of the one or more nuts 114 on the threaded fastener 112 may be adjusted accordingly. For instance, the height of the one or more nuts 114 on the threaded fastener 112 may be adjusted by adjusting a number of the one or more nuts 114 on the threaded fastener.

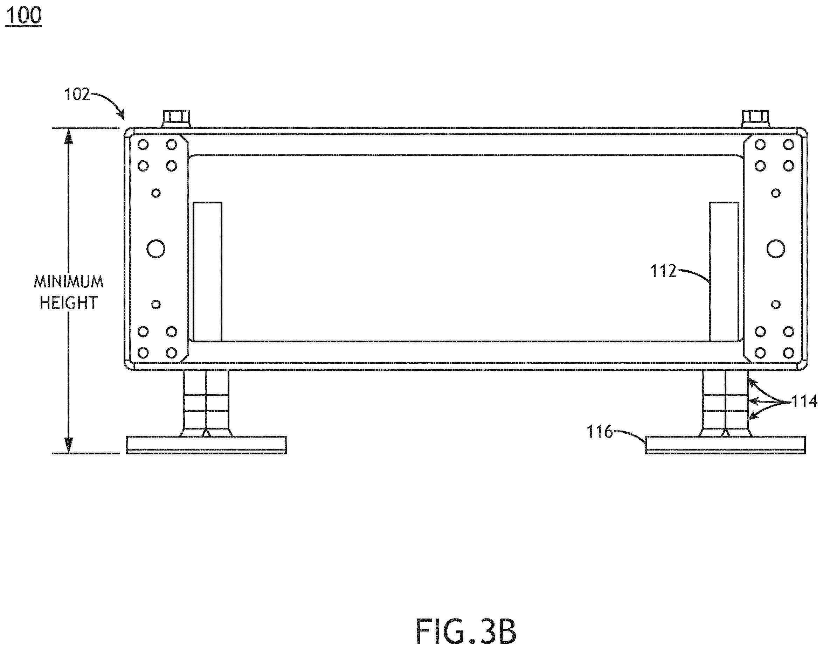

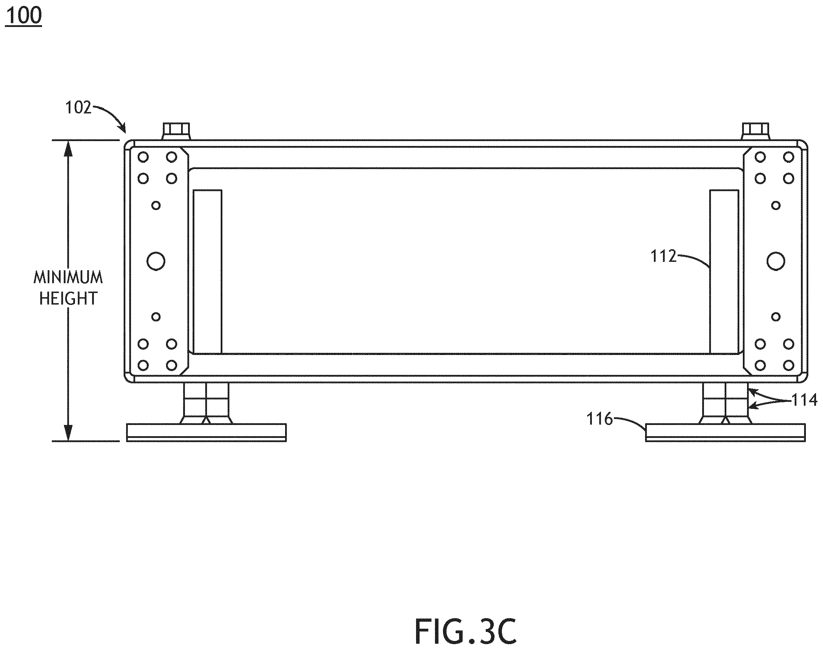

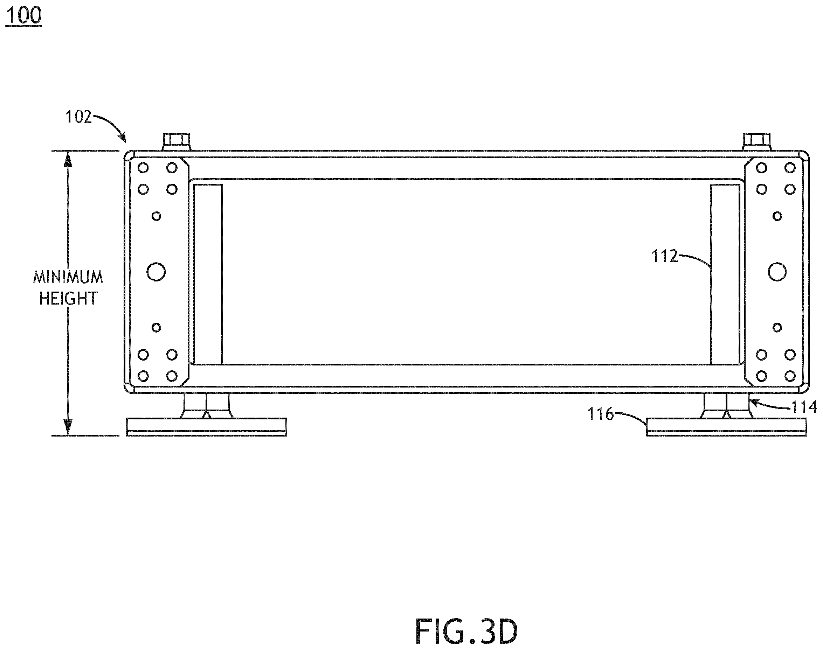

For example, in a non-limiting example shown in FIG. 3B, the mounting feet 110 may include three nuts 114 to achieve a predetermined first height of the modular base 102, such that the equipment 101 installed on the modular floor system 100 is even with the raised floor. By way of another non-limiting example, as shown in FIG. 3C, the mounting feet 110 may include two nuts 114 to achieve a predetermined second height of the modular base 102, such that the equipment 101 installed on the modular floor system 100 is even with the raised floor. By way of another non-limiting example, as shown in FIG. 3D, the mounting feet 110 may include a single nut 114 to achieve a predetermined third height of the modular base 102, such that the equipment 101 installed on the modular floor system 100 is even with the raised floor.

It is contemplated herein the FIGS. 3A-3D are provided merely for illustrative purposes and shall not be construed as limiting the scope of the present invention. The mounting feet 110 may include any configuration of fasteners 112/nuts 114 suitable for adjusting a height of a respective modular base 102. Further, nuts 114 with various thicknesses may be employed to facilitate height adjustment of a respective modular base 102.

It is noted that the height of the modular base 102 may be adjusted based on a height of the floor stand. In a non-limiting example, where the floor stand is 30,5 cm (12 inches), the height of the modular base 102 may be between approximately 24,8-36,2 cm (9.75-14.25 inches). In an additional non-limiting example, where the floor stand is 40,6 cm (16 inches), the height of the modular base 102 may be between approximately 34,9-46,4 cm (13.75-18.25 inches). In an additional non-limiting example, where the floor stand is 53,3 cm (21 inches), the height of the modular base 102 may be between approximately 44,5-64,8 cm (17.5-24.5 inches). In an additional non-limiting example, where the floor stand is 68,8 cm (27 inches), the height of the modular base 102 may be between approximately 59,7-77,5 cm (23.5-30.5 inches). In an additional non-limiting example, where the floor stand is 83,8 cm (33 inches), the height of the modular base 102 may be between approximately 74,9-92,7 cm (29.5-36.5 inches). In an additional non-limiting example, where the floor stand is 99,1 cm (39 inches), the height of the modular base 102 may be between approximately 90,2-108,0 cm (35.5-42.5 inches).

In a general sense, those skilled in the art will recognize that the various aspects described herein which can be implemented, individually and/or collectively, by a wide range of hardware, software, firmware, or any combination thereof can be viewed as being composed of various types of "electrical circuitry." Consequently, as used herein "electrical circuitry" includes, but is not limited to, electrical circuitry having at least one discrete electrical circuit, electrical circuitry having at least one integrated circuit, electrical circuitry having at least one application specific integrated circuit, electrical circuitry forming a general purpose computing device configured by a computer program (e.g., a general purpose computer configured by a computer program which at least partially carries out processes and/or devices described herein, or a microprocessor configured by a computer program which at least partially carries out processes and/or devices described herein), electrical circuitry forming a memory device (e.g., forms of random access memory), and/or electrical circuitry forming a communications device (e.g., a modem, communications switch, or optical-electrical equipment). Those having skill in the art will recognize that the subject matter described herein may be implemented in an analog or digital fashion or some combination thereof.

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

While particular aspects of the present subject matter described herein have been shown and described, it will be apparent to those skilled in the art that, based upon the teachings herein, changes and modifications may be made without departing from the subject matter described herein. Furthermore, it is to be understood that the invention is defined by the appended claims.

## Claims

1. A modular floor system (100), the modular floor system (100) comprising:
one or more modular floor bases (102), each modular floor base (102) comprising:
one or more base plates (104) ;
one or more framing members (106) , the one or more framing members (106) including one or more vertical framing members (106a) configured to couple to the one or more base plates (104), the one or more framing members (106) including one or more horizontal framing members (106b) configured to couple to the one or more vertical framing members (106a); and
one or more sidewall plates (108), the one or more sidewall plates (108) configured to couple to the one or more framing members (106), the one or more cavities (105) configured to support one or more pieces of equipment (101) on the one or more horizontal framing members (106b); and
one or more mounting feet (110) configured to mount the one or more modular floor bases (102) to a floor of a data center, a height of the one or more modular floor bases (102) configured to be adjusted via the one or more mounting feet (110).

2. The modular floor system (100) of claim 1, wherein the one or more sidewall plates (108) configured to couple to the one or more framing members (106) to form one or more cavities (105) defined by one or more surfaces of the one or more sidewall plates (108) and the one or more base plates (104).

3. The modular floor system (100) of claim 1 or 2, wherein the modular floor system (100) is installable on a subfloor of a data center, wherein the height of the one or more modular floor bases (102) is adjusted based on a height of a raised floor on the subfloor of the data center.

4. The modular floor system (100) of any of claims 1-3, wherein the one or more base plates (104) include one or more perforations (103).

5. The modular floor system (100) of any of claims 1-4, wherein the one or more sidewall plates (108) include one or more perforations (107).

6. The modular floor system (100) of any of claims 1-5, wherein the one or more sidewall plates (108) include one or more cable openings (109) configured to receive one or more cables from the one or more pieces of equipment (101) mounted within the one or more cavities (105).

7. The modular floor system (100) of any of claims 1-6, wherein the one or more mounting feet (110) include one or more threaded fasteners (117) and one or more nuts (112).

8. The modular floor system (100) of claim 7, wherein the height of the one or more modular floor bases (102) is configured to be adjusted by:
selecting a vertical position along a shaft of the one or more threaded fasteners(117); and
adjusting a height of the one or more nuts (112) on the shaft of the one or more threaded fasteners (117) based on the selected vertical position.

9. The modular floor system (100) of any of claims 1-8, further comprising:
one or more mounting s (113) configured to receive one or more mounting bolts (111), wherein the one or more mounting bolts (111) are configured to couple a first modular floor base (102) of the one or more modular floor bases (102) to at least a second modular floor base (102) of the one or more modular floor bases (102) arranged adjacent to the first modular floor base.

10. A system, the system comprising:
a modular floor system (100) according to any of the preceding claims, wherein the modular floor system (100) is a modular floor stand system comprising:
a plurality of modular floor bases (102), the plurality of modular floor bases (102) including a first modular floor base (102) arranged adjacent to at least a second modular floor base, the first modular floor base (102) configured to support a first piece of equipment (101) of one or more pieces of equipment (101), the second modular floor base (102) configured to support a second piece of equipment (101) of the one or more pieces of equipment (101),
each modular floor base (102) comprising:
one or more mounting holes (113) configured to receive one or more mounting bolts (111), wherein the one or more mounting bolts (111) are configured to couple the first modular floor base (102) of the one or more modular floor bases (102) to the at least the second modular floor base (102) of the one or more modular floor bases (102) arranged adjacent to the first modular floor base.

11. A system, the system comprising:
one or more pieces of equipment; and
a modular floor system (100) according to any of claims 1-9, wherein the modular floor (100) system is a modular floor stand system, wherein the modular floor stand system is installable on a subfloor of a data center.

12. A system according to claim 11, the one or more sidewall plates (108) and the one or more base plates (104) defining one or more cavities (105) when coupled to the one or more framing members (106).
